# EUROPÄISCHE PATENTANMELDUNG

(11) **EP 2 765 840 A2**
(43) Veröffentlichungstag der Anmeldung: **13.08.2014**
(21) Anmeldenummer: 13196860.4
(22) Anmeldetag: 12.12.2013
(51) Int. Cl.: H05K 1/18

(54) **Schaltungsanordnung**

(30) Priorität: 08.02.2013 DE 102013101266
(71) Anmelder: SEMIKRON Elektronik GmbH & Co. KG, 90431 Nürnberg (DE)
(72) Erfinder: Schleicher, Michael, 91058 Erlangen (DE)

(57) **Zusammenfassung**

Die Erfindung betrifft eine Schaltungsanordnung (1) mit einer Leiterplatte (2) und einem auf der Leiterplatte (2) angeordnetem elektrischen Bauelement (10), wobei die Leiterplatte (2) einen elektrisch nicht leitenden Isolierstoffkörper (4) aufweist, wobei auf einer ersten Seite (14) des Isolierstoffkörpers (4) elektrisch leitende Leiterbahnen (3) angeordnet sind, wobei das Bauelement (10) ein Gehäuse (9) und aus dem Gehäuse (9) herausragende elektrisch leitende Anschlusspins (6), die mit den Leiterbahnen (3) verbunden sind, aufweist, wobei die Leiterplatte (2) eine durch die Leiterplatte (2) hindurchgehende Ausnehmung (7) aufweist, wobei ein Teil des Gehäuses (9) des Bauelements (10) in der Ausnehmung (7) angeordnet ist. Die Erfindung schafft eine Schaltungsanordnung (1), die eine flache Bauform aufweist.

## Beschreibung

Die Erfindung betrifft eine Schaltungsanordnung.

Bei techniküblichen Schaltungsanordnungen sind auf einer Leiterplatte elektrische Bauelemente, wie z.B. Spulen, Übertrager, Kondensatoren, elektrische Widerstände, und/oder integrierte Schaltkreise auf einer Leiterplatte angeordnet und mit Hilfe von elektrisch leitenden Leitbahnen der Leiterplatte miteinander elektrisch leitend verbunden. Die Schaltungsanordnungen sollen dabei einen möglichst geringen Platzbedarf und insbesondere eine möglichst flache Bauform aufweisen.

Bei Leistungshalbleitereinrichtungen sind im Allgemeinen auf einem Substrat (z.B. DCB-Substrat) Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden.

Weiterhin weisen Leistungshalbleitereinrichtungen häufig auch zusätzlich Schaltungsanordnungen zur Ansteuerung der Leistungshalbleiterschalter auf. Die Schaltungsanordnungen erzeugen dabei die Ansteuersignale für die Steueranschlüsse (z.B. Gate) der Leistungshalbleiterschalter. Insbesondere bei Leistungshalbleitereinrichtungen sind Schaltungsanordnungen, die eine flache Bauform aufweisen und somit einen geringen Platzbedarf aufweisen, von Vorteil.

Es ist Aufgabe der Erfindung eine Schaltungsanordnung, die eine flache Bauform aufweist, zu schaffen.

Diese Aufgabe wird gelöst durch eine Schaltungsanordnung mit einer Leiterplatte und einem auf der Leiterplatte angeordnetem elektrischen Bauelement, wobei die Leiterplatte einen elektrisch nicht leitenden Isolierstoffkörper aufweist, wobei auf einer ersten Seite des Isolierstoffkörpers elektrisch leitende Leiterbahnen angeordnet sind, wobei das Bauelement ein Gehäuse und aus dem Gehäuse herausragende elektrisch leitende Anschlusspins, die mit den Leiterbahnen verbunden sind, aufweist, wobei die Leiterplatte eine durch die Leiterplatte hindurchgehende Ausnehmung aufweist, wobei ein Teil des Gehäuses des Bauelements in der Ausnehmung angeordnet ist.

Vorteilhafte Ausbildungen der Erfindung ergeben sich aus den abhängigen Ansprüchen.

Es erweist sich als vorteilhaft, wenn zwischen dem Gehäuse des Bauelements und dem Isolierstoffkörper ein um das Gehäuse des Bauelements umlaufender Spalt angeordnet ist, da dann die Positioniergenauigkeitsanforderungen der Elemente bei einer automatisierten Bestückung der Leiterplatte mit dem Bauelement reduziert ist.

In diesem Zusammenhang ist es vorteilhaft, wenn die Breite des Spalts in einem Bereich von 0,1 mm bis 5 mm liegt.

Weiterhin erweist es sich als vorteilhaft, wenn der Spalt Spaltbereiche aufweist, wobei die Spaltbereiche jeweilig entlang einer zugehörigen senkrecht zur Leiterplatte angeordneten Seite des Gehäuses verlaufen, wobei Spaltbereiche, die von den Anschlusspins überbrückt werden, eine größere Breite aufweisen als Spaltbereiche, die nicht von den Anschlusspins überbrückt werden. Durch diese Maßnahme kann eine hohe elektrische Isolationsfestigkeit der Schaltungsanordnung erzielt werden und die Größe der Ausnehmung der Leiterplatte optimiert werden.

Ferner erweist es sich als vorteilhaft, wenn das Gehäuse mit der den Anschlusspins abgewandten Seite der Leiterplatte über ein Klebemittel verbunden ist. Durch diese Maßnahme wird die mechanischen Festigkeit der erfindungsgemäßen Schaltungsanordnung erhöht und/oder eine einfache automatisierte Verlötung der Anschlusspins mit den Leiterbahnen ermöglicht.

Weiterhin erweist es sich als vorteilhaft, wenn der Spalt Spaltbereiche aufweist, wobei die Spaltbereiche jeweilig entlang einer zugehörigen senkrecht zur Leiterplatte angeordneten Seite des Gehäuses verlaufen, wobei das Klebemittel auf der den Anschlusspins abgewandten Seite der Leiterplatte mindestens zwei Spaltbereiche abdeckt. Das Klebemittel kann zusätzlich auch in den mindestens zwei Spaltbereiche angeordnet sein. Durch diese Maßnahme wird die mechanischen Festigkeit der erfindungsgemäßen Schaltungsanordnung erhöht und/oder eine einfache automatisierte Verlötung der Anschlusspins mit den Leiterbahnen ermöglicht.

Ferner erweist es sich als vorteilhaft, wenn das Klebemittel auf der den Anschlusspins abgewandten Seite der Leiterplatte alle Spaltbereiche abdeckt, da hierdurch eine besonders hohe mechanischen Festigkeit der erfindungsgemäßen Schaltungsanordnung erzielt wird.

Weiterhin erweist es sich als vorteilhaft, wenn die Anschlusspins aus einer parallel zur Leiterplatte verlaufenden ersten Seite des Gehäuses heraus verlaufen, wobei die erste Seite des Gehäuses innerhalb der Ausnehmung angeordnet ist. Hierdurch wird ein einfacher Aufbau der Schaltungsanordnung ermöglicht.

Weiterhin erweist es sich als vorteilhaft, wenn die Anschlusspins aus einer parallel zur Leiterplatte verlaufenden ersten Seite des Gehäuses heraus verlaufen, wobei die erste Seite des Gehäuses außerhalb der Ausnehmung angeordnet ist. Hierdurch kann das Bauelement in der senkrecht zur Leiterplatte verlaufenden Richtung variabel angeordnet werden und somit die Form die Schaltungsanordnung flexibel angepasst werden.

Ferner erweist es sich als vorteilhaft, wenn die Anschlusspins mindestens aus zwei gegenüberliegend senkrecht zur Leiterplatte verlaufenden Seiten des Gehäuses heraus verlaufen, wobei die Anschlusspins außerhalb der Ausnehmung verlaufen und eine parallel zur Leiterplatte verlaufende erste Seite des Gehäuses außerhalb der Ausnehmung angeordnet ist. Hierdurch kann das Bauelement in der senkrecht zur Leiterplatte verlaufenden Richtung variabel angeordnet werden und somit die Form der Schaltungsanordnung flexibel angepasst werden.

Weiterhin erweist es sich als vorteilhaft, wenn das Gehäuse mittels einer Schnapp-Rast-Verbindung mit der Leiterplatte verbunden ist. Hierdurch wird eine einfache automatisierte Verlötung der Anschlusspins mit den Leiterbahnen bei der Herstellung der Schaltungsanordnung ermöglicht, da eine mit dem Bauelement bestückte aber noch nicht mit dem Bauelement verlötete Leiterplatte beliebig im Raum bewegt werden kann, insbesondere gedreht werden kann, ohne dass das Bauelement aus der Ausnehmung der Leiterplatte fällt.

Ferner erweist es sich als vorteilhaft, wenn die Form der Ausnehmung derartig an die Form des Gehäuses angepasst ist, dass das Gehäuse kraftschlüssig mit dem Isolierstoffkörper verbunden ist. Hierdurch wird eine einfache automatisierte Verlötung der Anschlusspins mit den Leiterbahnen bei der Herstellung der Schaltungsanordnung ermöglicht, da eine mit dem Bauelement bestückte aber noch nicht mit dem Bauelement verlötete Leiterplatte beliebig im Raum bewegt werden kann, insbesondere gedreht werden kann, ohne dass das Bauelement aus der Ausnehmung der Leiterplatte fällt.

Weiterhin erweist es sich als vorteilhaft, wenn das elektrische Bauelement als Übertrager, Spule, Kondensator, elektrischer Widerstand oder als integrierter Schaltkreis ausgebildet ist, da diese übliche Ausbildungen des elektrischen Bauelements darstellen. Insbesondere, wenn das elektrische Bauelement eine hohe Bauform aufweist, erweist sich die Erfindung als besonders vorteilhaft.

Weiterhin erweist sich eine Leistungshalbleitereinrichtung mit mindestens einem Leistungshalbleiterschalter und mit der erfindungsgemäßen Schaltungsanordnung, wobei die Schaltungsanordnung zur Ansteuerung des mindestens einen Leistungshalbleiterschalters ausgebildet ist, als vorteilhaft, da dann die Leistungshalbleitereinrichtung baulich besonders klein realisiert werden kann. Es sei an dieser Stelle ausdrücklich angemerkt, dass die erfindungsgemäße Schaltungsanordnung selbstverständlich auch zu Realisierung von beliebig anderen Anwendungen bzw. elektrischen Schaltungen ausgebildet sein kann und eine Vielzahl von auf der Leiterplatte angeordnete elektrische Bauelemente aufweisen kann. Die elektrischen Bauelemente können insbesondere als SMD-Bauelemente ausgebildet sein.

Ausführungsbeispiele der Erfindung sind in den Figuren dargestellt und werden im Folgenden näher erläutert. Dabei zeigen:
- FIG 1: eine schematisierte Schnittansicht einer erfindungsgemäßen Schaltungsanordnung,
- FIG 2: eine schematisierte Draufsicht auf eine erfindungsgemäße Schaltungsanordnung,
- FIG 3: eine schematisierte Schnittansicht einer weiteren Ausbildung einer erfindungsgemäßen Schaltungsanordnung,
- FIG 4: eine schematisierte Schnittansicht einer weiteren Ausbildung einer erfindungsgemäßen Schaltungsanordnung,
- FIG 5: eine schematisierte Schnittansicht einer weiteren Ausbildung einer erfindungsgemäßen Schaltungsanordnung,
- FIG 6: eine schematisierte Schnittansicht einer weiteren Ausbildung einer erfindungsgemäßen Schaltungsanordnung und
- FIG 7: ein Blockschaltbild einer Leistungshalbleitereinrichtung.

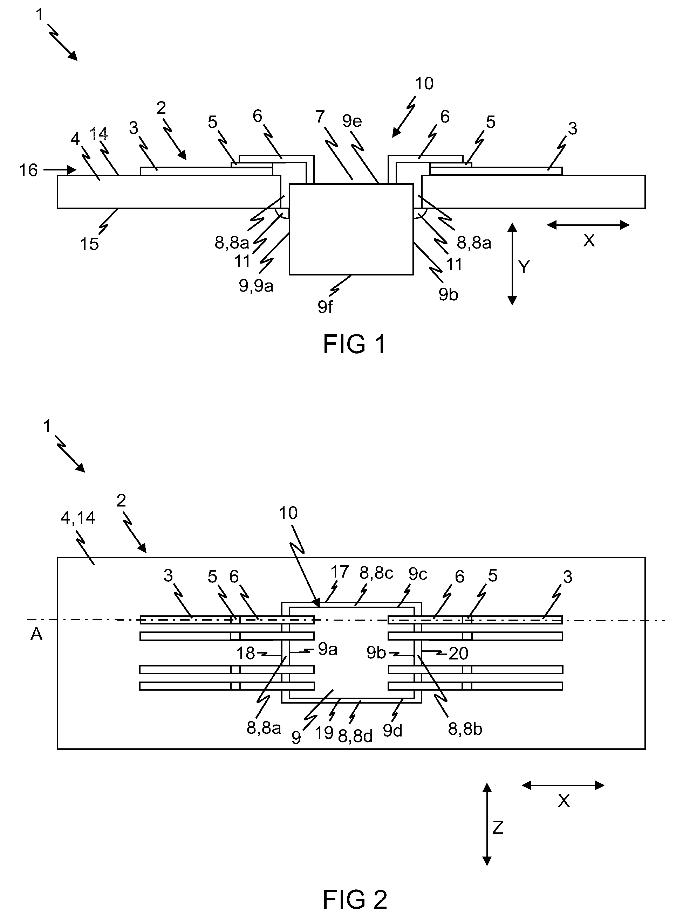

In FIG 1 ist eine schematisierte Schnittansicht einer erfindungsgemäßen Schaltungsanordnung 1 dargestellt. In FIG 2 ist eine schematisierte Draufsicht auf die erfindungsgemäße Schaltungsanordnung 1 dargestellt, wobei der in FIG 1 dargestellte Schnitt entlang der in FIG 2 dargestellten Linie A verläuft. Die Schaltungsanordnung 1 weist eine Leiterplatte 2 und ein auf der Leiterplatte 2 angeordnetes elektrisches Bauelement 10 auf. Die Leiterplatte 2 verläuft entlang der Richtung X und Z. Die Leiterplatte 2 weist einen elektrisch nicht leitenden Isolierstoffkörper 4 auf, wobei auf einer ersten Seite 14 des Isolierstoffkörpers 4 elektrisch leitende Leiterbahnen 3 angeordnet sind. Der Isolierstoffkörper 4 kann z.B. in Form eines Epoxidharzglasfasergewebes vorliegen oder aus einer Keramik bestehen. Auf dem Isolierstoffkörpers 4 ist eine elektrisch leitende strukturierte erste Leitungsschicht 16 angeordnet, die im Rahmen des Ausführungsbeispiels die Leiterbahnen 3 ausbildet. Die strukturierte erste Leitungsschicht 16 des Substrats 2 kann z.B. aus Kupfer bestehen. Es sei an dieser Stelle angemerkt, dass die erste Leitungsschicht 16 des Substrats 2 auch aus mehreren übereinanderliegenden Schichten bestehen kann. So kann die erste Leitungsschicht 16 z.B. eine Kupferschicht aufweisen, die eine einzelne oder mehrere übereinanderliegende Beschichtungen, z.B. aus einem Edelmetall (z.B. Silber) oder aus einer Edelmetallverbindung aufweist, welche z.B. als Haftvermittlungsschichten und/oder Schutzschichten dienen können. Die Leiterbahnen 3 können somit jeweilig auch mehrere Schichten aufweisen. Weiterhin sei angemerkt, dass die Leiterplatte 2 z.B. auch auf der der ersten Seite 14 des Isolierstoffkörpers 4 gegenüberliegend angeordneten zweiten Seite 15 des Isolierstoffkörpers 4 angeordnete Leiterbahnen aufweisen kann, die in analoger Form wie die Leiterbahnen 3 ausgebildet sein können. Die Leiterplatte kann auch als Multilayer Leiterplatte ausgebildet sein.

Das elektrische Bauelement 10 weist ein Gehäuse 9 und aus dem Gehäuse 9 herausragende elektrisch leitende Anschlusspins 6 , die mit den Leiterbahnen 3 verbunden sind, auf. Die Anschlusspins 6 verlaufen im Rahmen des Ausführungsbeispiels aus einer parallel zur Leiterplatte 2 verlaufenden ersten Seite 9e des Gehäuses 9 heraus, wobei die erste Seite 9e des Gehäuses innerhalb der Ausnehmung 7 angeordnet ist. Im Rahmen des Ausführungsbeispiels sind die Anschlusspins 6 mittels einer Lötschicht 5 mit den Leiterbahnen 3 verbunden. Das elektrische Bauelement 10 kann z.B. als Übertrager, insbesondere als induktiver Übertrager, als Spule, als Kondensator, als elektrischer Widerstand oder als integrierter Schaltkreis ausgebildet sein. Es sei angemerkt, dass die erfindungsgemäße Schaltungsanordnung selbstverständlich auch mehrere auf der Leiterplatte angeordnete elektrische Bauelemente aufweisen kann.

Erfindungsgemäß weist die Leiterplatte 2 eine durch die Leiterplatte 2 hindurchgehende Ausnehmung 7 auf, wobei ein Teil des Gehäuses 9 des Bauelements 10 in der Ausnehmung 7 angeordnet ist. Die Seitenwände 17, 18, 19 und 20 der Ausnehmung 7 sind umlaufend um das Gehäuse 9 angeordnet. Die Leiterplatte 2 umschließt lateral das Gehäuse 9. Der Teil des Gehäuses 9 des Bauelements 10, der nicht in der Ausnehmung 7 angeordnet ist, ragt aus der Leiterplatte 2 heraus. Da ein Teil des Gehäuses 9 des Bauelements 10 in der Ausnehmung 7 angeordnet ist, weist die erfindungsgemäße Schaltungsanordnung 1 einen flachen Aufbau und somit einen geringen Platzbedarf auf. Es sei angemerkt, dass die erfindungsgemäße Schaltungsanordnung selbstverständlich auch mehrere entsprechende Ausnehmungen aufweisen kann.

Vorzugsweise ist zwischen dem Gehäuse 9 des Bauelements 10 und dem Isolierstoffkörper 4 ein um das Gehäuse 9 des Bauelements 10 umlaufender Spalt 8 angeordnet. Die Breite des Spalts 8 liegt vorzugsweise in einem Bereich von 0,1 mm bis 5 mm.

Die Breite das Spalts 8 kann um das Gehäuse 9 herum konstant sein, sie kann aber auch entlang des Gehäuses 9 variieren. So weist im Rahmen des Ausführungsbeispiels der Spalt 8 Spaltbereiche 8a, 8b, 8c und 8d auf, wobei die Spaltbereiche entlang einer jeweilig zugehörigen senkrecht zur Leiterplatte 2 angeordneten Seite 9a, 9b, 9c bzw. 9d des Gehäuses 9 verlaufen, wobei die Spaltbereiche 8a und 8b, die von den Anschlusspins 6 überbrückt werden, eine größere Breite aufweisen als die Spaltbereiche 8c und 8d, die nicht von den Anschlusspins 6 überbrückt werden. Durch diese Maßnahme können zur Sicherstellung der elektrischen Isolationsfestigkeit gezielt die Kriechstrecken zwischen den in den Figuren linksseitig angeordneten Anschlusspins des Bauelements 10 und den in den Figuren rechtsseitig angeordneten Anschlusspins des Bauelements 10 vergrößert werden bzw. an die jeweilig geforderte elektrische Isolationsfestigkeit angepasst werden. Insbesondere bei einem Übertrager (z.B. bei einem induktiven Übertrager) können zwischen den in den Figuren linksseitig und rechtsseitig angeordneten Anschlusspins des Bauelements 10 hohe elektrische Potentialdifferenzen vorhanden sein, die zuverlässig voneinander elektrisch isoliert sein müssen. Das technikübliche Einbringen von Gräben in den Isolierstoffkörper 4 zur Vergrößerung der Kriechstrecke kann somit bei der erfindungsgemäßen Schaltungsanordnung entfallen.

Vorzugsweise ist zur Erhöhung der mechanischen Festigkeit der erfindungsgemäßen Schaltungsanordnung und/oder um eine einfache automatisierte Verlötung der Anschlusspins 6 mit den Leiterbahnen 3 zu ermöglichen, das Gehäuse 9 mit der den Anschlusspins 6 abgewandten Seite der Leiterplatte 4, die im Rahmen des Ausführungsbeispiels in Form der zweiten Seite 15 des Isolierstoffkörper 4 vorliegt, über ein Klebemittel 11 verbunden. Das Klebemittel 11 kann z.B. in Form eines Silikons vorliegen. Vorzugsweise deckt das Klebemittel 11 auf der den Anschlusspins 6 abgewandten Seite der Leiterplatte 2 mindestens zwei Spaltbereiche ab, wobei die betreffenden Spaltbereiche, die mit dem Klebemittel 11 abgedeckt sind, vorzugsweise zueinander gegenüberliegend angeordnet sind. Eine besonders hohe mechanische Festigkeit der erfindungsgemäßen Schaltungsanordnung 1 wird erreicht, wenn das Klebemittel 11 auf der den Anschlusspins 6 abgewandten Seite der Leiterplatte alle Spaltbereiche abdeckt, d.h. den kompletten Spalt 8 abdeckt.

Bei techniküblichen Schaltungsanordnungen können die Gehäuse der Bauelemente in der Regel, da die Anschlusspins der Bauelemente aus Kontroll- und Servicegründen im Allgemeinen nicht mit Klebemittel abgedeckt werden sollen, nur an den Seiten an denen keine Anschlusspins des jeweiligen Bauelements angeordnet sind, also in der Regel nur an zwei Seiten des Gehäuses des jeweiligen Bauelements, mittels eines Klebemittels, mit der Leiterplatte verbunden werden. Eine beliebe Auswahl der Seiten des Gehäuses, die mit der Leiterplatte verbunden werden sollen, ist somit im Allgemeinen bei techniküblichen Schaltungsanordnungen nicht möglich. Bei direkter aneinander Anreihung von Bauelementen können zudem bei techniküblichen Schaltungsanordnungen oftmals die in der Mitte angeordneten Bauelemente gar nicht mit der Leiterplatte verklebt werden, so dass dieser nur über die Anschlusspins mit der Leiterplatte verbunden sind und somit technikübliche Schaltungsanordnungen oftmals eine unzureichende mechanische Stabilität aufweisen, da die Bauelemente nicht stabil genug mit der Leiterplatte verbunden sind.

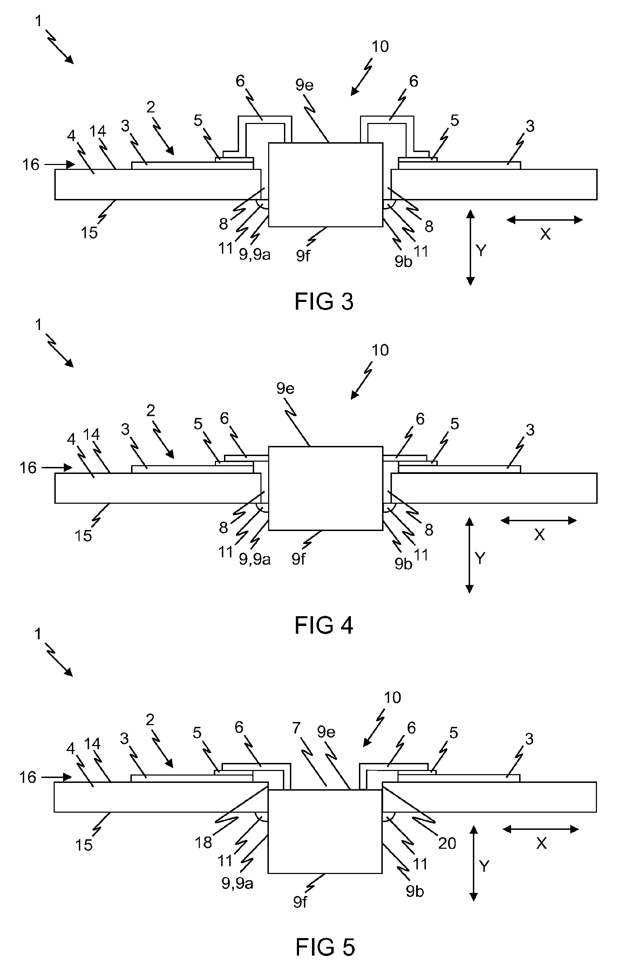

In FIG 3 ist eine schematisierte Schnittansicht einer weiteren erfindungsgemäßen Schaltungsanordnung 1 dargestellt. Die Schaltungsanordnung 1, gemäß FIG 3, stimmt mit der Schaltungsanordnung 1, gemäß FIG 1, bis auf das Merkmal überein, dass bei der Schaltungsanordnung 1, gemäß FIG 3, die erste Seite 9e des Gehäuses 9 aus der die Anschlusspins 6 des Bauelements 10 heraus verlaufen, au ßerhalb der Ausnehmung 7 angeordnet ist. Gegebenenfalls ist auch die der ersten Seite 9e gegenüberliegend angeordnete zweite Seite 9f des Gehäuses 9 außerhalb der Ausnehmung 7 angeordnet.

In FIG 4 ist eine schematisierte Schnittansicht einer weiteren erfindungsgemäßen Schaltungsanordnung 1 dargestellt. Die Schaltungsanordnung 1, gemäß FIG 4, stimmt mit der Schaltungsanordnung 1, gemäß FIG 1, bis auf das Merkmal überein, dass bei der Schaltungsanordnung 1, gemäß FIG 4, die Anschlusspins 6 mindestens aus zwei gegenüberliegend senkrecht zur Leiterplatte 2 verlaufenden Seiten 9a und 9b des Gehäuses 9 heraus verlaufen, wobei die Anschlusspins 6 außerhalb der Ausnehmung 7 verlaufen und die parallel zur Leiterplatte 4 verlaufende erste Seite 9e des Gehäuses 9 außerhalb der Ausnehmung 7 angeordnet ist. Gegebenenfalls ist die der ersten Seite 9e gegenüberliegend angeordnete zweite Seite 9f des Gehäuses 9 ebenfalls außerhalb der Ausnehmung 7 angeordnet.

Wie in FIG 3 und FIG 4 dargestellt, kann das Bauelement 10 solchermaßen in der senkrecht zur Leiterplatte 2 verlaufenden Richtung Y variabel angeordnet werden und somit die Form der erfinderischen Schaltungsanordnung 1 flexibel an die jeweiligen geometrischen Bedürfnisse angepasst werden.

In FIG 5 ist eine schematisierte Schnittansicht einer weiteren erfindungsgemäßen Schaltungsanordnung 1 dargestellt. Die Schaltungsanordnung 1, gemäß FIG 5, stimmt mit der Schaltungsanordnung 1, gemäß FIG 1, bis auf das Merkmal überein, dass die Form der Ausnehmung 7 derartig an die Form des Gehäuses 9 angepasst ist, dass das Gehäuse 9 kraftschlüssig mit dem Isolierstoffkörper 4 verbunden ist. Mindestens zwei gegenüberliegende Seitenwände der Ausnehmung 7 weisen hierzu voneinander einen Abstand auf, der gleich oder geringfügig kleiner ist als der Abstand der an die betreffenden Seitenwände der Ausnehmung 7 angeordneten Seiten des Gehäuses 9. Die Seitenwände der Ausnehmung 7 üben eine Kraft auf das Gehäuse 9 aus, so dass dieses in der Ausnehmung 7 verbleibt, nachdem es in die Ausnehmung 7 eingeführt ist. Das Bauelement 10 wird solchermaßen von den Seitenwänden der Ausnehmung 7 gehalten. Im Rahmen des Ausführungsbeispiels ist der Abstand zwischen den beiden gegenüberliegenden Seitenwände 18 und 20 der Ausnehmung 7 geringfügig kleiner als der Abstand der Seiten 9a und 9b des Gehäuses 9, so dass eine Presspassung entsteht. Diese Ausführungsform erlaubt eine einfache automatisierte Verlötung der Anschlusspins 6 mit den Leiterbahnen 3 bei der Herstellung der Schaltungsanordnung 1, gemäß FIG 5, da eine mit dem Bauelement 10 bestückte aber noch nicht mit dem Bauelement 10 verlötete Leiterplatte 2 beliebig im Raum bewegt, insbesondere gedreht, werden kann, ohne dass das Bauelement 10 aus der Ausnehmung 7 der Leiterplatte 2 fällt. Zur Steigerung der mechanischen Festigkeit kann das Gehäuse 9 zusätzlich mit der den Anschlusspins 6 abgewandten Seite der Leiterplatte 4 über das Klebemittel 11 verbunden sein.

Selbstverständlich kann auch bei den in FIG 3 und FIG4 dargestellten erfindungsgemäßen Schaltungsanordnungen 1 in analoger Weise wie bei Schaltungsanordnung 1, gemäß FIG 5, die Form der Ausnehmung 7 derartig an die Form des Gehäuses 9 angepasst sein, dass das Gehäuse 9 kraftschlüssig mit dem Isolierstoffkörper 4 verbunden ist.

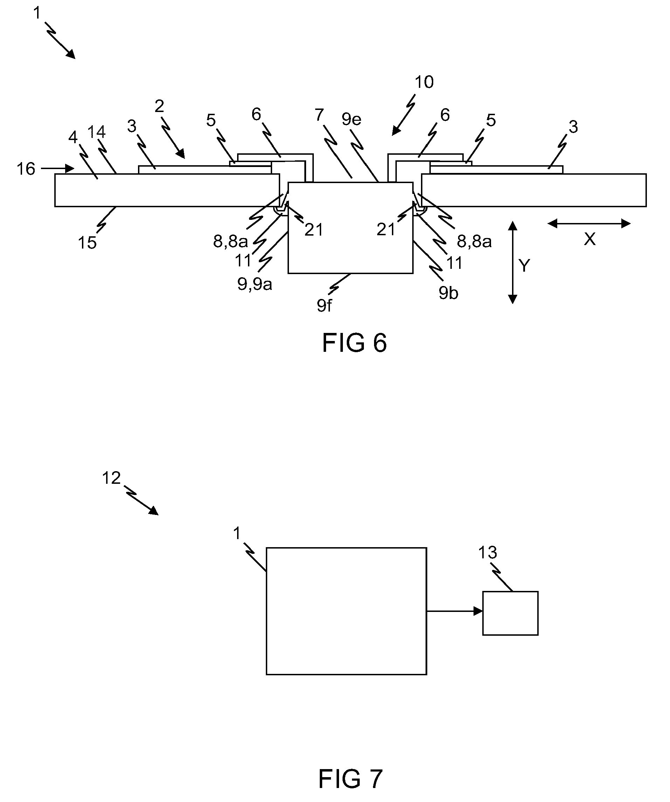

In FIG 6 ist eine schematisierte Schnittansicht einer weiteren erfindungsgemäßen Schaltungsanordnung 1 dargestellt. Die Schaltungsanordnung 1, gemäß FIG 6, stimmt mit der Schaltungsanordnung 1, gemäß FIG 1, bis auf das Merkmal überein, dass bei der Schaltungsanordnung 1, gemäß FIG 6, das Gehäuse 9 mittels einer Schnapp-Rast-Verbindung mit der Leiterplatte 2 verbunden ist. Das Gehäuse 9 ist zur Realisierung der Schnapp-Rast-Verbindung über mindestens einen Schnapphacken 21 mit dem Leiterplatte 2 verbunden. Vorzugsweise ist der mindestens eine Schnapphacken 21 einstückig mit dem Gehäuse 9 ausgebildet. Das Bauelement 10 wird solchermaßen von der Leiterplatte 2 gehalten. Diese Ausführungsform erlaubt eine einfache automatisierte Verlötung der Anschlusspins 6 mit den Leiterbahnen 3 bei der Herstellung der Schaltungsanordnung 1, gemäß FIG 6, da eine mit dem Bauelement 10 bestückte aber noch nicht mit dem Bauelement 10 verlötete Leiterplatte 2 beliebig im Raum bewegt, insbesondere gedreht, werden kann, ohne dass das Bauelement 10 aus der Ausnehmung 7 der Leiterplatte 2 fällt. Zur Steigerung der mechanischen Festigkeit kann das Gehäuse 9 zusätzlich mit der den Anschlusspins 6 abgewandten Seite der Leiterplatte 4 über das Klebemittel 11 verbunden sein.

Selbstverständlich kann auch bei den in FIG 3 und FIG4 dargestellten erfindungsgemäßen Schaltungsanordnungen 1 in analoger Weise wie bei Schaltungsanordnung 1, gemäß FIG 6, das Gehäuse 9 mittels einer Schnapp-Rast-Verbindung mit der Leiterplatte 2 verbunden sein.

In FIG 7 ist ein Blockschaltbild einer Leistungshalbleitereinrichtung 12 dargestellt. Die Leistungshalbleitereinrichtung 12 weist mindestens einen Leistungshalbleiterschalter 13 und die erfindungsgemäße Schaltungsanordnung 1 auf, wobei die Schaltungsanordnung 1 zur Ansteuerung des mindestens einen Leistungshalbleiterschalters ausgebildet ist, d.h. sie erzeugt das Ansteuersignal für den Steueranschluss (z.B. Gate) des mindestens einen Leistungshalbleiterschalters 13. Im Falle von mehreren Leistungshalbleiterschaltern erzeugt sie für die von ihr angesteuerten Leistungshalbleiterschalter ein jeweiliges Ansteuersignal. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor. Der mindestens eine Leistungshalbleiterschalter 13 ist auf einem Substrat, wie z.B. einem DCB-Substrat, angeordnet und mittels einer Leiterschicht des Substrats, sowie Bonddrähten und/oder einem Folienverbund elektrisch leitend mit anderen Elementen der Leistungshalbleitereinrichtung 12 verbunden. Im Falle von mehreren Leistungshalbleiterschaltern sind die auf dem Substrat angeordneten Leistungshalbleiterschalter dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden.

## Patentansprüche

1. Schaltungsanordnung mit einer Leiterplatte (2) und einem auf der Leiterplatte (2) angeordnetem elektrischen Bauelement (10), wobei die Leiterplatte (2) einen elektrisch nicht leitenden Isolierstoffkörper (4) aufweist, wobei auf einer ersten Seite (14) des Isolierstoffkörpers (4) elektrisch leitende Leiterbahnen (3) angeordnet sind, wobei das Bauelement (10) ein Gehäuse (9) und aus dem Gehäuse (9) herausragende elektrisch leitende Anschlusspins (6), die mit den Leiterbahnen (3) verbunden sind, aufweist, wobei die Leiterplatte (2) eine durch die Leiterplatte (2) hindurchgehende Ausnehmung (7) aufweist, wobei ein Teil des Gehäuses (9) des Bauelements (10) in der Ausnehmung (7) angeordnet ist.

2. Schaltungsanordnung nach Anspruch 1, **dadurch gekennzeichnet, dass** zwischen dem Gehäuse (9) des Bauelements (10) und dem Isolierstoffkörper (4) ein um das Gehäuse (9) des Bauelements (10) umlaufender Spalt (8) angeordnet ist.

3. Schaltungsanordnung nach Anspruch 2, **dadurch gekennzeichnet, dass** die Breite des Spalts (8) in einem Bereich von 0,1 mm bis 5 mm liegt.

4. Schaltungsanordnung nach Anspruch 2 oder 3, **dadurch gekennzeichnet, dass** der Spalt (8) Spaltbereiche (8a,8b,8c,8d) aufweist, wobei die Spaltbereiche (8a,8b,8c,8d) jeweilig entlang einer zugehörigen senkrecht zur Leiterplatte (2) angeordneten Seite (9a,9b,9c,9d) des Gehäuses (9) verlaufen, wobei Spaltbereiche (8a,8b,8c,8d), die von den Anschlusspins (6) überbrückt werden, eine größere Breite aufweisen als Spaltbereiche (8a,8b,8c,8d), die nicht von den Anschlusspins (6) überbrückt werden.

5. Schaltungsanordnung nach einem der vorhergehenden Ansprüche, **dadurch gekennzeichnet, dass** das Gehäuse (9) mit der den Anschlusspins (6) abgewandten Seite (15) der Leiterplatte (4) über ein Klebemittel (11) verbunden ist.

6. Schaltungsanordnung nach Anspruch 5, **dadurch gekennzeichnet, dass** der Spalt (8) Spaltbereiche (8a,8b,8c,8d) aufweist, wobei die Spaltbereiche (8a,8b,8c,8d) jeweilig entlang einer zugehörigen senkrecht zur Leiterplatte (4) angeordneten Seite (9a,9b,9c,9d) des Gehäuses (9) verlaufen, wobei das Klebemittel (11) auf der den Anschlusspins (6) abgewandten Seite (15) der Leiterplatte (4) mindestens zwei Spaltbereiche (8a,8b,8c,8d) abdeckt.

7. Schaltungsanordnung nach Anspruch 6, **dadurch gekennzeichnet, dass** das Klebemittel (11) auf der den Anschlusspins (6) abgewandten Seite (15) der Leiterplatte (4) alle Spaltbereiche (8a,8b,8c,8d) abdeckt.

8. Schaltungsanordnung nach einem der vorhergehenden Ansprüche, **dadurch gekennzeichnet, dass** die Anschlusspins(6) aus einer parallel zur Leiterplatte (4) verlaufenden ersten Seite (9e) des Gehäuses (9) heraus verlaufen, wobei die erste Seite (9e) des Gehäuses (9) innerhalb der Ausnehmung (7) angeordnet ist.

9. Schaltungsanordnung nach einem der Ansprüche 1 bis 7, **dadurch gekennzeichnet, dass** die Anschlusspins (6) aus einer parallel zur Leiterplatte (4) verlaufenden ersten Seite (9e) des Gehäuses (9) heraus verlaufen, wobei die erste Seite (9e) des Gehäuses (9) außerhalb der Ausnehmung (7) angeordnet ist.

10. Schaltungsanordnung nach einem der Ansprüche 1 bis 7, **dadurch gekennzeichnet, dass** die Anschlusspins (6) mindestens aus zwei gegenüberliegend senkrecht zur Leiterplatte (4) verlaufenden Seiten (9a,9b) des Gehäuses (9) heraus verlaufen, wobei die Anschlusspins (6) au ßerhalb der Ausnehmung (7) verlaufen und eine parallel zur Leiterplatte (4) verlaufende erste Seite (9e) des Gehäuses (9) außerhalb der Ausnehmung (7) angeordnet ist.

11. Schaltungsanordnung nach einem der vorhergehenden Ansprüche, **dadurch gekennzeichnet, dass** das Gehäuse (9) mittels einer Schnapp-Rast-Verbindung mit der Leiterplatte (2) verbunden ist.

12. Schaltungsanordnung nach einem der Ansprüche 1, 5, 8, 9 oder 10, **dadurch gekennzeichnet, dass** die Form der Ausnehmung (7) derartig an die Form des Gehäuses (9) angepasst ist, dass das Gehäuse (9) kraftschlüssig mit dem Isolierstoffkörper (4) verbunden ist.

13. Schaltungsanordnung nach einem der vorhergehenden Ansprüche, **dadurch gekennzeichnet, dass** das elektrische Bauelement (10) als Übertrager, Spule, Kondensator, elektrischer Widerstand oder als integrierter Schaltkreis ausgebildet ist.

14. Leistungshalbleitereinrichtung mit mindestens einem Leistungshalbleiterschalter (13) und mit einer Schaltungsanordnung (1) nach einem der vorhergehenden Ansprüche, wobei die Schaltungsanordnung (1) zur Ansteuerung des mindestens einen Leistungshalbleiterschalters (13) ausgebildet ist.
